(19) Europäisches Patentamt
European Patent Office
Office européen des brevets

(11) **EP 4 641 899 A1**

(12) **EUROPEAN PATENT APPLICATION**

(43) Date of publication:
**29.10.2025 Bulletin 2025/44**

(21) Application number: **25172365.6**

(22) Date of filing: **24.04.2025**

(51) International Patent Classification (IPC):
**H02M 1/00** (2006.01)     **H02M 1/32** (2007.01)
**H02M 1/36** (2007.01)     **H02M 3/156** (2006.01)

(52) Cooperative Patent Classification (CPC):
**H02M 1/32; H02M 1/0009; H02M 1/36;**
**H02M 3/156;** Y02E 10/56

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **24.04.2024  CN 202410516314**

(71) Applicant: **Huawei Digital Power Technologies**
**Co., Ltd.**
**Shenzhen, Guangdong 518043 (CN)**

(72) Inventors:
• **WANG, Xiaohui**
 **Shenzhen 518043 (CN)**
• **ZHAO, Jing**
 **Shenzhen 518043 (CN)**
• **FU, Mingxiao**
 **Shenzhen 518043 (CN)**
• **QIU, Xiaodong**
 **Shenzhen 518043 (CN)**
• **TANG, Shun**
 **Shenzhen 518043 (CN)**

(74) Representative: **Gill Jennings & Every LLP**
**The Broadgate Tower**
**20 Primrose Street**
**London EC2A 2ES (GB)**

(54) **POWER CONVERTER AND METHOD FOR MEASURING INDUCTANCE VALUE OF INDUCTOR IN POWER CONVERTER**

(57)     This application provides a power converter and a method for measuring an inductance value of an inductor in the power converter. The power converter includes a controller and a direct current-direct current conversion circuit. An input of the direct current-direct current conversion circuit is configured to connect to a photovoltaic module. The direct current-direct current conversion circuit includes the inductor, a main switch, and a diode. The controller is configured to: in a start process of the power converter, control the main switch in the direct current-direct current conversion circuit to be turned on or turned off, to collect a waveform of a current flowing through the inductor; when the collected waveform of the current flowing through the inductor is discontinuous, obtain an inductance value of the inductor based on the waveform of the current flowing through the inductor; and output an inductor exception alarm signal when the inductance value of the inductor is less than a first threshold. The power converter can obtain the inductance value of the inductor when the current flowing through the inductor is discontinuous, to monitor a status of the inductor, thereby improving reliability of the power converter.

FIG. 1

## Description

## TECHNICAL FIELD

This application relates to the field of power electronics technologies, and in particular, to a power converter and a method for measuring an inductance value of an inductor in the power converter.

## BACKGROUND

An inductor (inductor) is a common circuit component that generates an electromotive force due to a change of a current flowing through the inductor, thereby resisting the change of the current. The inductor can store energy based on this characteristic. A power converter in a photovoltaic system may use the inductor in a main circuit, to implement conversion between direct currents of various voltages.

In actual application, in start and running processes of the power converter, an inter-turn short circuit may occur in a coil winding of the inductor in the power converter, which causes a circuit to be overheated and damaged, may even cause a fire, and the like. Therefore, an inductance value needs to be measured in real time to monitor a status of the inductor. When an exception occurs in the inductor, an alarm is generated in time to improve system safety.

Some existing inductance measurement solutions are only applicable to a case in which the current of the inductor keeps continuous in a switching period. However, an inductor exception usually occurs when the power converter is just started. At this time, the current flowing through the inductor is in a discontinuous state. Therefore, a proper manner for measuring the inductance value of the inductor needs to be explored to monitor the inductor.

## SUMMARY

This application provides a power converter and a method for measuring an inductance value of an inductor in the power converter, so that the inductance value of the inductor can be obtained when a current flowing through the inductor is in a discontinuous state, and a status of the inductor can be monitored, thereby improving reliability and safety of the power converter.

According to a first aspect, this application provides a power converter. The power converter may include a controller and a direct current-direct current conversion circuit. An input of the direct current-direct current conversion circuit may be configured to connect to a photovoltaic module. The direct current-direct current conversion circuit may include an inductor, a main switch, and a diode. A first end of the inductor is connected to a positive input of the direct current-direct current conversion circuit. A second end of the inductor is connected to a positive electrode of the diode and a first end of the main switch. A negative electrode of the diode is connected to a positive output of the direct current-direct current conversion circuit. A second end of the main switch is connected to a negative input of the direct current-direct current conversion circuit. When the main switch is turned on, the inductor stores energy. When the main switch is turned off, the inductor releases energy. In this case, the direct current-direct current conversion circuit may be a boost circuit.

The controller may be configured to: in a start process of the power converter, control the main switch to be turned on or turned off, to collect a waveform of a current flowing through the inductor. When the collected waveform of the current flowing through the inductor is discontinuous, the controller may be further configured to obtain an inductance value of the inductor based on the waveform of the current flowing through the inductor. The controller outputs an inductor exception alarm signal when the inductance value of the inductor is less than a first threshold. The discontinuous waveform of the current flowing through the inductor may occur when the power converter is just started. That the waveform of the current flowing through the inductor is discontinuous may specifically mean that when the main switch is turned off, the current flowing through the inductor is zero for a period of time.

In this application, a status of the waveform of the current flowing through the inductor is obtained in the start process of the power converter, and the inductance value of the inductor is obtained when the current flowing through the inductor is discontinuous. In this way, the inductor can be monitored, whether the inductor is abnormal in the start process of the power converter can be detected in time, and the inductor exception alarm signal is output for a prompt when the inductor is abnormal, thereby discovering and rectifying a fault in time, and improving reliability of the power converter.

In a feasible implementation, the controller in the power converter is specifically configured to: in the start process of the power converter, control the main switch to be turned on or turned off, and obtain, in a period of a drive signal of the main switch, a plurality of instantaneous values of the current flowing through the inductor, to obtain the waveform of the current flowing through the inductor. When at least two consecutive instantaneous values of the current in the plurality of instantaneous values of the current are zero, it is determined that the waveform of the current flowing through the inductor is discontinuous. The at least two consecutive instantaneous values of the current are obtained through at least two consecutive samplings. When the at least two consecutive instantaneous values of the current in the plurality of instantaneous values of the current are zero, it may indicate that the current flowing through the inductor is zero for a period of time. Therefore, it may be determined that the waveform of the current flowing through the inductor is discontinuous. In this manner, whether the waveform of the current flowing through the inductor is discontinuous can be quickly determined, so that it can be determined whether the inductance value of the inductor is obtained through calculation by using the algorithm provided in this application, which is simple in principle and easy to operate.

In a feasible implementation, the controller in the power converter is specifically configured to: in the start process of the power converter, control the main switch to be turned on or turned off, and obtain, in a period of a drive signal of the main switch, a plurality of instantaneous values of the current flowing through the inductor, to obtain the waveform of the current flowing through the inductor. When an average value of the plurality of instantaneous values of the current is less than a second threshold, it is determined that the waveform of the current flowing through the inductor is discontinuous. The second threshold may be determined based on an actual scenario. When the average value of the plurality of instantaneous values of the current is small, it indicates that there may be some zero values in the plurality of instantaneous values of the current. Therefore, it may be determined that the waveform of the current flowing through the inductor is discontinuous. On the contrary, when the waveform of the current flowing through the inductor is continuous, the instantaneous values of the current flowing through the inductor is usually not zero. In this case, the average value of the plurality of instantaneous values of the current may be large. In this way, the average value of the plurality of instantaneous values of the current is compared with the second threshold, so that whether the current flowing through the inductor is always large can be determined, to further distinguish whether the current flowing through the inductor is discontinuous. This manner is simple and easy to implement, and helps quickly monitor the inductance value of the inductor.

In a feasible implementation, when the waveform of the current flowing through the inductor is discontinuous, the controller in the power converter may obtain the inductance value of the inductor based on the plurality of instantaneous values of the current flowing through the inductor that are obtained in the period of the drive signal, an input voltage and an output voltage that are of the direct current-direct current conversion circuit and that are obtained in the period, duration of the period, and a duty cycle of the drive signal. In this way, when the waveform of the current flowing through the inductor in the power converter is discontinuous, the controller may obtain an actual inductance value of the inductor through calculation based on the obtained data such as the current of the inductor, voltages at two ends of the inductor, and the period and the duty cycle of the drive signal. In this way, whether the inductor is abnormal can be monitored, thereby improving reliability of the power converter when the power converter is just started, and the monitoring manner is simple and easy to implement.

In a feasible implementation, the controller in the power converter may be configured to: obtain an average value of the current of the inductor based on the plurality of instantaneous values of the current, and obtain the inductance value of the inductor based on the average value of the current of the inductor, the input voltage, the output voltage, the duration of the period, and the duty cycle.

In a feasible implementation, the controller in the power converter may be configured to: obtain a voltage difference based on the output voltage and the input voltage, and obtain the inductance value of the inductor based on the average value of the current of the inductor, the input voltage, the output voltage, the voltage difference, the duration of the period, and the duty cycle. In this way, a formula for calculating the inductance value of the inductor may be derived based on the data, the waveform of the current flowing through the inductor, and the like, to obtain the inductance value of the inductor. In this manner, no additional circuit element needs to be added, and a status of the inductor can be monitored based on basic data and a simple calculation manner. This helps detect an inductor exception in time when the power converter is just started, improves circuit reliability and safety, and is convenient and flexible.

In a feasible implementation, the power converter may further include a current collection unit. The plurality of instantaneous values of the current include N instantaneous values of the current. The current collection unit is configured to: averagely collect, in the period, instantaneous values of the current flowing through the inductor for N times, to obtain the N instantaneous values of the current, and send the N instantaneous values of the current to the controller. Correspondingly, the controller may receive the N instantaneous values of the current, and obtain the inductance value of the inductor through calculation based on the data. In this way, whether the current of the inductor is discontinuous may be obtained based on the N instantaneous values of the current collected by the current collection unit. In addition, when the current of the inductor is discontinuous, calculation is performed based on the data, to obtain the inductance value of the inductor, and further monitor the inductor, thereby improving reliability of the entire power converter.

In a feasible implementation, the power converter may further include a voltage collection unit. The voltage collection unit is configured to: collect the input voltage and the output voltage of the direct current-direct current conversion circuit in the period, and send the input voltage and the output voltage to the controller. Correspondingly, the controller may receive the input voltage and the output voltage, and obtain the inductance value of the inductor through calculation based on the data. In this way, by using the voltage collection unit, the controller can obtain reliable data, to obtain the inductance value of the inductor based on the data, thereby monitoring the inductor and improving reliability of the entire power converter.

In a feasible implementation, the power converter further includes an inverter circuit. An input of the inverter circuit is connected to an output of the direct current-direct current conversion circuit. An output of the inverter circuit is configured to connect to a power grid or a load. In this way, the power converter can convert a direct current into an alternating current. By monitoring the inductor in the power converter, reliability of the entire power converter can be improved.

According to a second aspect, this application provides a method for measuring an inductance value of an inductor in a power converter. The method includes:

in a start process of the power converter, controlling a main switch in a direct current-direct current conversion circuit included in the power converter to be turned on or turned off, to collect a waveform of a current flowing through the inductor in the direct current-direct current conversion circuit;

when the collected waveform of the current flowing through the inductor is discontinuous, obtaining an inductance value of the inductor based on the waveform of the current flowing through the inductor; and

outputting an inductor exception alarm signal when the obtained inductance value of the inductor is less than a first threshold.

In a feasible implementation, in the start process of the power converter, the controlling a main switch in a direct current-direct current conversion circuit included in the power converter to be turned on or turned off, to collect a waveform of a current flowing through the inductor in the direct current-direct current conversion circuit specifically includes:

in the start process of the power converter, controlling the main switch in the direct current-direct current conversion circuit to be turned on or turned off, and obtaining, in a period of a drive signal of the main switch, a plurality of instantaneous values of the current flowing through the inductor, to obtain the waveform of the current flowing through the inductor.

When at least two consecutive instantaneous values of the current of the inductor in the plurality of instantaneous values of the current are zero, it is determined that the waveform of the current of the inductor is discontinuous.

In a feasible implementation, in the start process of the power converter, the controlling a main switch in a direct current-direct current conversion circuit included in the power converter to be turned on or turned off, to collect a waveform of a current flowing through the inductor in the direct current-direct current conversion circuit specifically includes:

in the start process of the power converter, controlling the main switch in the direct current-direct current conversion circuit to be turned on or turned off, and obtaining, in a period of a drive signal of the main switch, a plurality of instantaneous values of the current flowing through the inductor, to obtain the waveform of the current flowing through the inductor.

When an average value of the plurality of instantaneous values of the current is less than a second threshold, it is determined that the waveform of the current of the inductor is discontinuous.

In a feasible implementation, when the waveform of the current flowing through the inductor is discontinuous, the inductance value of the inductor is obtained based on the plurality of instantaneous values of the current flowing through the inductor that are obtained in the period of the drive signal, an input voltage and an output voltage that are of the direct current-direct current conversion circuit and that are obtained in the period, duration of the period, and a duty cycle of the drive signal.

In a feasible implementation, an average value of the current of the inductor is obtained based on the plurality of instantaneous values of the current, and the inductance value of the inductor is obtained based on the average value of the current of the inductor, the input voltage, the output voltage, the duration of the period, and the duty cycle.

In a feasible implementation, a voltage difference is obtained based on the output voltage and the input voltage, and the inductance value of the inductor is obtained based on the average value of the current of the inductor, the input voltage, the output voltage, the voltage difference, the duration of the period, and the duty cycle.

In this application, the waveform of the current flowing through the inductor when the power converter is just started is analyzed. When it is determined that the waveform of the current flowing through the inductor is discontinuous, the inductance value of the inductor is obtained based on the waveform of the current flowing through the inductor. In this way, a status of the inductor can be monitored, circuit damage caused by an inductor exception occurred when the power converter is just started is avoided, which can improve reliability and safety of the power converter. In the inductance measurement manner, no additional circuit element needs to be added, and costs are low. The manner can be implemented when the power converter operates, does not affect operating of the power converter, and is convenient and flexible.

**BRIEF DESCRIPTION OF DRAWINGS**

FIG. 1 is a diagram of an application scenario of a power converter according to this application;

FIG. 2 is a diagram of a structure of a DC/DC conversion circuit in a power converter according to this application;

FIG. 3 is a diagram of a structure of a power converter according to this application;

FIG. 4 is a diagram of a time-varying current flowing through an inductor in a power converter according to this application; and

FIG. 5 is a schematic flowchart of a method for measuring an inductance value of an inductor in a power converter according to this application.

## DESCRIPTION OF EMBODIMENTS

A power converter provided in this application may be applicable to a plurality of application fields such as a new energy smart micro grid field, a power transmission and distribution field, a new energy field, and an energy storage field. The power converter provided in this application may include a direct current (direct current, DC)/direct current DC conversion circuit. In some scenarios, the power converter may further include a direct current DC/alternating current (alternating current, AC) conversion circuit. The power converter may be an inverter, an energy storage converter, a direct current converter, a switch-mode power supply, or the like, and may be used in various scenarios such as a photovoltaic power supply scenario, an energy storage power supply scenario, and a scenario in which power is supplied to a communication base station. This application is described by using an example in which the power converter is used in the photovoltaic power supply scenario and includes both the DC/DC conversion circuit and the DC/AC conversion circuit.

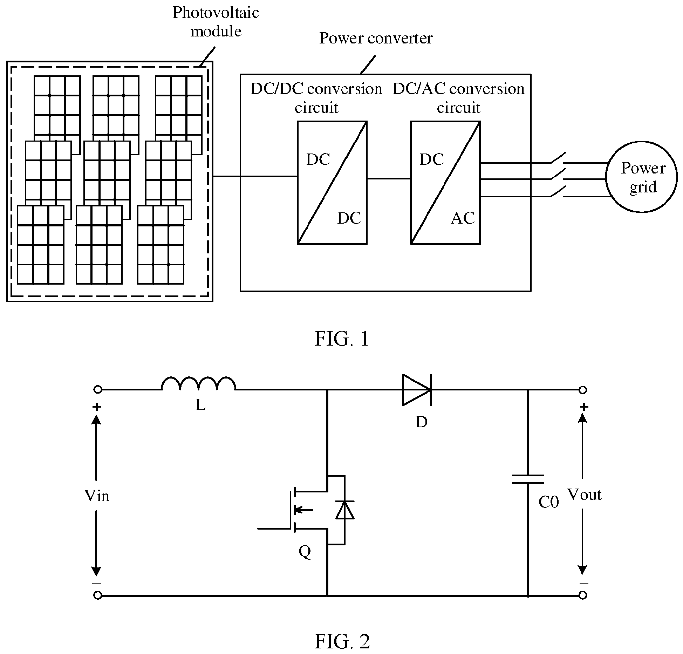

FIG. 1 is a diagram of an application scenario of a power converter according to this application. In a photovoltaic power supply scenario, the power converter may be a photovoltaic inverter. The power converter may include a DC/DC conversion circuit and a DC/AC conversion circuit (which may also be referred to as an inverter circuit). The DC/DC conversion circuit may include one or more levels of direct current conversion circuits. An input of the DC/DC conversion circuit may be configured to connect to a photovoltaic module. An output of the DC/DC conversion circuit is connected to an input of the DC/AC conversion circuit. An output of the DC/AC conversion circuit may be configured to connect to a power grid or a load (not shown in FIG. 1). As shown in FIG. 1, the photovoltaic module may be configured to provide a direct current input for the DC/DC conversion circuit in the power converter. The DC/DC conversion circuit may convert a direct current provided by the photovoltaic module into a direct current that has another output characteristic. The DC/AC conversion circuit in the power converter may invert the direct current output by the DC/DC conversion circuit into an alternating current, to supply power to the power grid or the load. It may be understood that the foregoing DC/DC conversion circuit may include elements such as an inductor and a switch. Direct current conversion is implemented by using the inductor and the switch together. In this case, the inductor in the DC/DC conversion circuit is a power inductor.

An example in which the DC/DC conversion circuit is a boost circuit is used for description. As shown in FIG. 2, in this case, the DC/DC conversion circuit may include an inductor L, a main switch Q, and a diode D. A first end of the inductor L is connected to a positive input of the DC/DC conversion circuit. A second end of the inductor L is connected to a positive electrode of the diode D and a first end of the main switch Q. A negative electrode of the diode is connected to a positive output of the DC/DC conversion circuit. A second end of the main switch Q is connected to a negative input of the DC/DC conversion circuit. A control end of the main switch Q receives a drive signal. An output capacitor C0 is connected between the positive output and a negative output of the DC/DC conversion circuit. In the circuit, when the main switch Q is turned on, the inductor L stores energy. When the main switch Q is turned off, the inductor L releases energy. When the main switch is turned on, the inductor stores energy. When the main switch is turned off, the inductor releases energy. The boost circuit may be configured to boost an input voltage Vin to an output voltage Vout. It may be understood that when an exception occurs in the inductor in the foregoing DC/DC conversion circuit, reliability of the power converter is easily affected. Therefore, an inductance value of the inductor needs to be monitored.

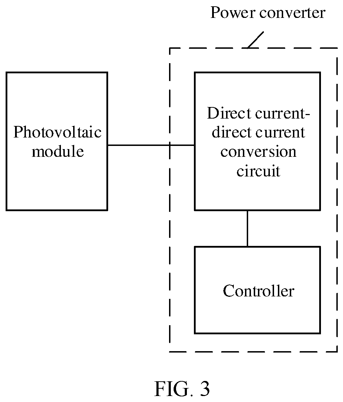

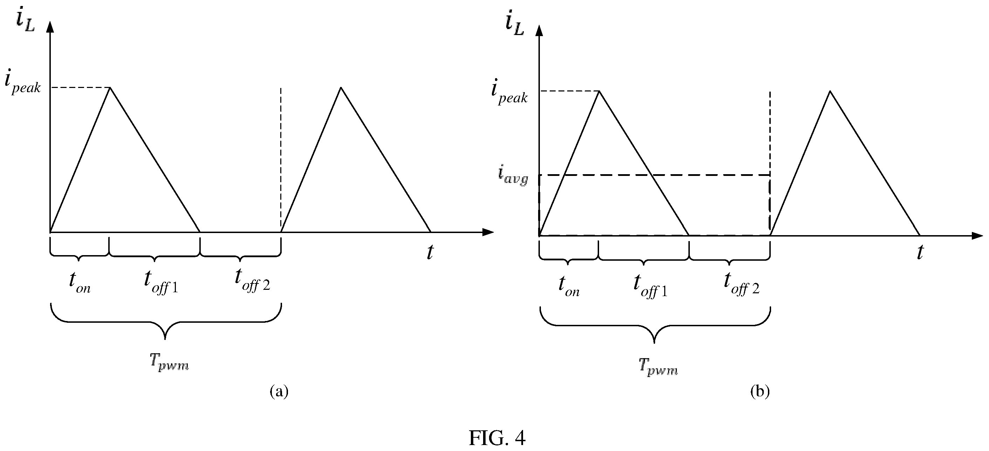

The following describes the power converter provided in this application with reference to FIG. 3 and FIG. 4.

FIG. 3 is a diagram of a structure of the power converter according to this application. As shown in FIG. 3, the power converter may include a controller and a direct current-direct current conversion circuit. The direct current-direct current conversion circuit may be the foregoing DC/DC conversion circuit. When the power converter is used in a photovoltaic power supply scenario, an input of the direct current-direct current conversion circuit may be configured to connect to a photovoltaic module. Optionally, when the power converter is used in another scenario, the input of the direct current-direct current conversion circuit may be further connected to an energy storage battery or another direct current power supply. This is not limited in this application. The direct current-direct current conversion circuit may include an inductor, a main switch, and a diode. A first end of the inductor is connected to a positive input of the direct current-direct current conversion circuit. A second end of the inductor is connected to a positive electrode of the diode and a first end of the main switch. A negative electrode of the diode is connected to a positive output of the direct current-direct current conversion circuit. A second end of the main switch is connected to a negative input of the direct current-direct current conversion circuit. For example, a structure of the direct current-direct current conversion circuit may be that shown in FIG. 2. The main switch may be a relay, a contactor, a transistor, an insulated-gate bipolar transistor (Insulated-Gate Bipolar Transistor, IGBT), a metal-oxide-semiconductor field-effect transistor (metal-oxide-semiconductor field-effect transistor, MOSFET), or the like. A specific type of the main switch is not limited in this application.

The controller in the power converter may be configured to: in a start process of the power converter, control the main switch in the direct current-direct current conversion circuit to be turned on or turned off, to collect a waveform of a current flowing through the inductor. When the collected waveform of the current flowing through the inductor is discontinuous, the controller may be further configured to obtain an inductance value of the inductor based on the waveform of the current flowing through the inductor. The controller may be further configured to output an inductor exception alarm signal when the inductance value of the inductor is less than a first threshold. It may be understood that in the start process of the power converter, an exception such as an inter-turn short circuit easily occurs in the inductor. Consequently, reliability of the power converter is reduced. Usually, when the power converter is just started, the waveform of the current flowing through the inductor may be discontinuous. Herein, that the waveform of the current flowing through the inductor is discontinuous may specifically mean that when the main switch is turned off, the current flowing through the inductor is zero for a period of time. The first threshold may be determined based on an actual scenario. For example, the first threshold may be set to half of a normal value of the inductor. This is not limited in this application. It may be understood that when the obtained inductance value of the inductor is less than the first threshold, an inter-turn short circuit may occur in the inductor, which may easily cause the circuit to be damaged due to temperature rise. Therefore, reliability of the power converter can be improved.

In this application, a status of the waveform of the current flowing through the inductor is obtained in the start process of the power converter, and the inductance value of the inductor is obtained when the current flowing through the inductor is discontinuous. In this way, the inductor can be monitored, whether the inductor is abnormal in the start process of the power converter can be detected in time, and the inductor exception alarm signal is output for a prompt when the inductor is abnormal, thereby discovering and rectifying a fault in time, and improving reliability of the power converter.

In a feasible implementation, the controller in the power converter may control, in the start process of the power converter, the main switch in the direct current-direct current conversion circuit to be turned on or turned off, obtain, in a period of a drive signal of the main switch, a plurality of instantaneous values of the current flowing through the inductor, and determine whether the waveform of the current flowing through the inductor is discontinuous based on the plurality of instantaneous values of the current. Herein, the drive signal is used to drive the main switch to be turned on or turned off. For example, the drive signal may be a pulse width modulation (Pulse Width Modulation, PWM) signal. It may be understood that in the start process of the power converter, the current flowing through the inductor may change as the main switch is turned on or turned off. The plurality of instantaneous values of the current flowing through the inductor can be collected and analyzed, to obtain the status of the waveform of the current flowing through the inductor.

Specifically, based on the plurality of instantaneous values of the current, the controller may determine, in a plurality of manners, whether the waveform of the current flowing through the inductor is discontinuous. The following describes two manners by using examples.

Manner 1: The controller in the power converter may be configured to: when at least two consecutive instantaneous values of the current in the plurality of instantaneous values of the current are zero, it is determined that the waveform of the current flowing through the inductor is discontinuous. The plurality of instantaneous values of the current are obtained in a same period of the drive signal. Herein, the at least two consecutive instantaneous values of the current mean that these instantaneous values of the current are obtained through at least two consecutive samplings. For example, if sampling is performed N times in a period, and instantaneous values $i_m$, $i_{m+1}$, and $i_{m+2}$ of the current are obtained by sampling at an $m^{th}$ time, an $(m+1)^{th}$ time, and an $(m+2)^{th}$ time respectively, the instantaneous values $i_m$, $i_{m+1}$, and $i_{m+2}$ of the current are three continuous instantaneous values of the current. It may be understood that when the at least two consecutive instantaneous values of the current in the plurality of instantaneous values of the current are zero, it may indicate that the current flowing through the inductor is zero for a period of time. Therefore, it may be determined that the waveform of the current flowing through the inductor is discontinuous. In this manner, whether the waveform of the current flowing through the inductor is discontinuous can be quickly determined, so that it can be determined whether the inductance value of the inductor is obtained through calculation by using the algorithm provided in this application, which is simple in principle and easy to operate.

Manner 2: The controller in the power converter may be configured to: when an average value of the plurality of instantaneous values of the current is less than a second threshold, it is determined that the waveform of the current flowing through the inductor is discontinuous. Herein, the plurality of instantaneous values of the current are a plurality of instantaneous values that are obtained in the period of the drive signal and that are of the current flowing through the inductor. It may be understood that the second threshold may be determined based on an actual scenario. When the average value of the plurality of instantaneous values of the current is small, it indicates that there may be some zero values in the plurality of instantaneous values of the current. Therefore, it may be determined that the waveform of the current flowing through the inductor is discontinuous. On the contrary, when the waveform of the current flowing through the inductor is continuous, the instantaneous values of the current flowing through the inductor is usually not zero. In this case, the average value of the plurality of instantaneous values of the current may be large. In this way, the average value of the plurality of instantaneous values of the current is compared with the second threshold, so that whether the current flowing through the inductor is always large can be determined, to further distinguish whether the current flowing through the inductor is discontinuous. This manner is simple and easy to implement, and helps quickly monitor the inductance value of the inductor.

In a feasible implementation, when the waveform of the current flowing through the inductor is discontinuous, the controller in the power converter may obtain the inductance value of the inductor based on the plurality of instantaneous values of the current flowing through the inductor that are obtained in the period of the drive signal, an input voltage and an output voltage that are of the direct current-direct current conversion circuit and that are obtained in the period, duration of the period, and a duty cycle of the drive signal. When the direct current-direct current conversion circuit is the boost circuit shown in FIG. 2, the input voltage and the output voltage of the direct current-direct current conversion circuit may be a voltage at the first end of the inductor and a voltage at the second end of the inductor, that is, Vin and Vout in FIG. 2.

In this application, when the waveform of the current flowing through the inductor in the power converter is discontinuous, the controller may obtain an actual inductance value of the inductor through calculation based on the obtained data such as the current of the inductor, voltages at two ends of the inductor, and the period and the duty cycle of the drive signal. In this way, whether the inductor is abnormal can be monitored, thereby improving reliability of the power converter when the power converter is just started, and the monitoring manner is simple and easy to implement.

In a feasible implementation, the power converter may further include a current collection unit. The plurality of instantaneous values of the current may include N instantaneous values of the current. The current collection unit may be configured to: averagely collect, in the period of the drive signal, instantaneous values of the current flowing through the inductor for N times. For example, in the period of the drive signal, when the drive signal is a high-level signal, a plurality of instantaneous values of the current are averagely collected. When the drive signal is a low-level signal, a plurality of instantaneous values of the current are averagely collected, to obtain accurate and representative current data, obtain the N instantaneous values of the current flowing through the inductor, and send the N instantaneous values of the current to the controller. Correspondingly, the controller may receive the N instantaneous values of the current, and obtain the inductance value of the inductor through calculation based on the data. In this way, whether the current of the inductor is discontinuous may be obtained based on the N instantaneous values of the current collected by the current collection unit. In addition, when the current of the inductor is discontinuous, calculation is performed based on the data, to obtain the inductance value of the inductor, and further monitor the inductor, thereby improving reliability of the entire power converter.

In a feasible implementation, the power converter may further include a voltage collection unit. The voltage collection unit may be configured to: collect the input voltage and the output voltage of the direct current-direct current conversion circuit in the period of the drive signal, and send the input voltage and the output voltage to the controller. Correspondingly, the controller may receive the input voltage and the output voltage, and obtain the inductance value of the inductor through calculation based on the data. In this way, by using the voltage collection unit, the controller can obtain reliable data, to obtain the inductance value of the inductor based on the data, thereby monitoring the inductor and improving reliability of the entire power converter.

In a feasible implementation, the controller in the power converter may be configured to: obtain an average value of the current of the inductor based on the plurality of instantaneous values of the current, and obtain the inductance value of the inductor based on the average value of the current of the inductor, the input voltage, the output voltage, the duration of the period, and the duty cycle.

Further, the controller in the power converter may be configured to: obtain a voltage difference based on the output voltage and the input voltage that are of the direct current-direct current conversion circuit, and obtain the inductance value of the inductor based on the average value of the current of the inductor, the input voltage, the output voltage, the voltage difference, the duration of the period of the drive signal, and the duty cycle. Herein, the direct current-direct current conversion circuit may include a boost circuit. The following uses an example in which the direct current-direct current conversion circuit is the boost circuit shown in FIG. 2 to specifically describe a process of obtaining the inductance value of the inductor through calculation based on these parameters.

When the waveform of the current flowing through the inductor is discontinuous, a case in which the current flowing through the inductor changes with time is shown in (a) in FIG. 4. In a period $T_{pwm}$ of the drive signal, duration when the main switch is turned on is $t_{on}$, duration when the main switch is turned off is $t_{off1} + t_{off2}$, and the current flowing through the inductor is zero within $t_{off2}$. When the main switch is turned on, the input voltage of the boost circuit charges the inductor, and the current flowing through the inductor increases. When the main switch is turned off, the inductor discharges through an output capacitor, the current flowing through the inductor decreases, and the current of the inductor keeps being zero for a period of time. In this application, a triangle enclosed by a time axis and the current flowing through the inductor may be equivalent to a rectangle. As shown in (b) in FIG. 4, the average current flowing through the inductor within the period of the drive signal is used to calculate the inductance value. Details are as follows: Assuming that a quantity of times for sampling a current $i_L$

flowing through the inductor within the period of the drive signal is N, an average value $i_{avg}$ of the current flowing through the inductor within the period (that is, the average value of the plurality of instantaneous value of the current) is as follows:

$$i_{avg} = \frac{1}{N}\sum_1^N i_L \quad (1)$$

The input voltage Vin of the direct current-direct current conversion circuit is denoted as $U_c$, and the output voltage Vout of the direct current-direct current conversion circuit is denoted as $U_{bus}$. Within the period $T_{pwm}$ of the drive signal, it can be learned from FIG. 4 and a relationship between the current flowing through the inductor and a voltage and time that a peak value $i_{peak}$ of the current flowing through the inductor is as follows:

$$i_{peak} = \frac{U_c}{L}t_{on} \quad (2)$$

Because a variation of a flux of the inductor within the duration $t_{on}$ when the main switch is turned on is the same as that within the duration $t_{off1}$ when the main switch is turned off, the following can be obtained:

$$t_{off1} = \frac{U_c}{U_{bus} - U_c}t_{on} \quad (3)$$

When the current flowing through the inductor is discontinuous, the period $T_{pwm}$ of the drive signal may include the following three parts:

$$T_{pwm} = t_{on} + t_{off1} + t_{off2} \quad (4)$$

In the period of the drive signal, an area S of the triangle enclosed by the time axis and the current flowing through the inductor may be calculated according to the following formula:

$$\begin{aligned} S &= \frac{1}{2}\left(t_{on} + t_{off1}\right)i_{peak} \\ &= \frac{1}{2}\left(t_{on} + t_{off1}\right)\frac{U_c}{L}t_{on} \\ &= \frac{1}{2}\left(t_{on} + \frac{U_c}{U_{bus} - U_c}t_{on}\right)\frac{U_c}{L}t_{on} \\ &= \frac{1}{2L}\frac{U_c U_{bus}}{U_{bus} - U_c}t_{on}^2 \quad \# \ (5) \end{aligned}$$

If the triangle enclosed by the time axis and the current flowing through the inductor is equivalent to a rectangle (a dashed-line box rectangle shown in (b) in FIG. 4), and the duty cycle of the drive signal is defined as

$D = t_{on}/T_{pwm}$, the average value $i_{avg}$ of the current flowing through the inductor may be as follows:

$$\begin{aligned} i_{avg} &= \frac{S}{T_{pwm}} \\ &= \frac{1}{2LT_{pwm}}\frac{U_c U_{bus}}{U_{bus} - U_c}t_{on}^2 \\ &= \frac{1}{2LT_{pwm}}\frac{U_c U_{bus}}{U_{bus} - U_c}\left(DT_{pwm}\right)^2 \\ &= \frac{1}{2L}\frac{U_c U_{bus}}{U_{bus} - U_c}D^2 T_{pwm} \quad \# \ (6) \end{aligned}$$

According to the foregoing formula, a formula for calculating the inductance value of the inductor L is as follows:

$$L = \frac{U_c U_{bus} D^2 T_{pwm}}{2i_{avg}(U_{bus} - U_c)} \quad \# \ (7)$$

It can be learned from the foregoing derivation that the inductance value of the inductor L is obtained based on the average value $i_{avg}$ of the current of the inductor, the input voltage $U_c$, the output voltage $U_{bus}$, the voltage difference $U_{bus} - U_c$, the duration $T_{pwm}$ of the period of the drive signal, and the duty cycle D.

In the foregoing implementation, an example in which the direct current-direct current circuit includes the boost circuit is used for description. Optionally, the power converter may further include an inverter circuit. An input of the inverter circuit may be connected to an output of the boost circuit. An output of the inverter circuit may be configured to connect to a power grid or a load. The foregoing manner for measuring the inductance value of the inductor may also be applicable to these power converters.

In this application, the power converter analyzes the plurality of instantaneous values of the current flowing through the inductor that are obtained in the period of the drive signal. When it is determined that the current flowing through the inductor is discontinuous, the power converter may obtain the inductance value of the inductor through calculation based on the plurality of instantaneous values of the current that are obtained in the period, the input voltage and the output voltage that are of the direct current-direct current conversion circuit, the period and the duty cycle of the drive signal. In this way, a status of the inductor can be monitored, circuit damage caused by an inductor exception occurred when the power converter is just started is avoided, which can improve reliability and safety of the power converter. In the inductor measurement manner, no additional circuit element needs to be added, and costs are low. The manner can be implemented when the power converter operates, does not affect operating of the power converter, and is convenient and flexible.

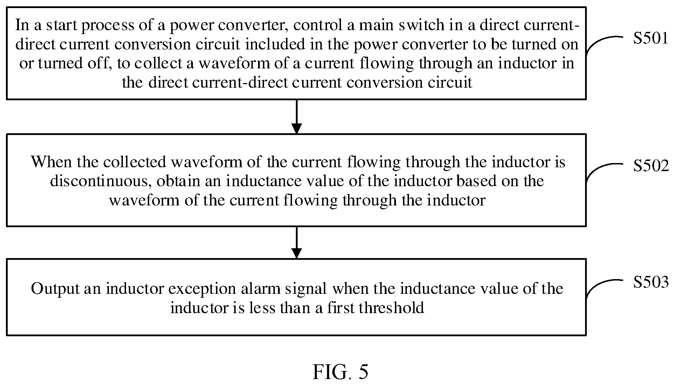

FIG. 5 is a schematic flowchart of a method for measuring an inductance value of an inductor in a power converter according to this application. As shown in FIG. 5, the method may include but is not limited to the following steps.

S501: In a start process of the power converter, control a main switch in a direct current-direct current conversion circuit included in the power converter to be turned on or turned off, to collect a waveform of a current flowing through the inductor in the direct current-direct current conversion circuit.

The power converter may include an inductor and a main switch. The inductor and the main switch work together to enable the power converter to implement boost conversion. The power converter may include the direct current-direct current conversion circuit shown in FIG. 2. In this case, the direct current-direct current conversion circuit may further include a diode. A first end of the inductor in the direct current-direct current conversion circuit is connected to a positive input of the direct current-direct current conversion circuit. A second end of the inductor is connected to a positive electrode of the diode and a first end of the main switch. A negative electrode of the diode is connected to a positive output of the direct current-direct current conversion circuit. A second end of the main switch is connected to a negative input of the direct current-direct current conversion circuit. A control end of the main switch receives a drive signal. An output capacitor is connected between the positive output and a negative output of the direct current-direct current conversion circuit. In the circuit, when the main switch is turned on, the inductor stores energy. When the main switch is turned off, the inductor releases energy. When the main switch is turned on, the inductor stores energy. When the main switch is turned off, the inductor releases energy. The direct current-direct current conversion circuit may be configured to boost an input voltage to an output voltage.

The main switch may be a relay, a contactor, a transistor, an insulated-gate bipolar transistor (Insulated Gate Bipolar Transistor, IGBT), a metal-oxide-semiconductor field-effect transistor (metal-oxide-semiconductor field-effect transistor, MOSFET), or the like. A specific type of the main switch is not limited in this application.

Herein, the waveform of the current flowing through the inductor may be discontinuous. That the waveform of the current flowing through the inductor is discontinuous may specifically mean that when the main switch is turned off, the current flowing through the inductor is zero for a period of time.

In a possible implementation, specifically, a plurality of instantaneous values of the current flowing through the inductor in the direct current-direct current conversion circuit may be obtained in a period of the drive signal of the main switch, to collect the waveform of the current flowing through the inductor.

S502: When the collected waveform of the current flowing through the inductor is discontinuous, obtain an inductance value of the inductor based on the waveform of the current flowing through the inductor.

In a possible implementation, when at least two consecutive instantaneous values of the current of the inductor in the plurality of instantaneous values of the current are zero, it is determined that the waveform of the current flowing through the inductor is discontinuous.

In a possible implementation, when an average value of the plurality of instantaneous values of the current is less than a second threshold, it is determined that the waveform of the current flowing through the inductor is discontinuous.

In a possible implementation, when the waveform of the current flowing through the inductor in the power converter is discontinuous, the inductance value of the inductor may be obtained based on the plurality of instantaneous values of the current flowing through the inductor that are obtained in the period of the drive signal, an input voltage and an output voltage that are of the direct current-direct current conversion circuit and that are obtained in the period, duration of the period, and a duty cycle of the drive signal.

During specific implementation, an average value of the current of the inductor may be first obtained based on the plurality of instantaneous values of the current, and the inductance value of the inductor is obtained based on the average value of the current of the inductor, the input voltage, the output voltage, the duration of the period, and the duty cycle.

Further, a voltage difference may be further obtained based on the output voltage and the input voltage, and the inductance value of the inductor is obtained based on the average value of the current of the inductor, the input voltage, the output voltage, the voltage difference, the duration of the period, and the duty cycle. For a specific derivation process of obtaining the inductance value of the inductor based on the data, refer to the derivation process of the foregoing formulas (1) to formula (7). Details are not described herein again.

S503: Output an inductor exception alarm signal when the inductance value of the inductor is less than a first threshold.

The first threshold may be determined based on an actual scenario. For example, the first threshold may be set to half of a normal value of the inductor. This is not limited in this application.

It may be understood that when the obtained inductance value of the inductor is less than the first threshold, an inter-turn short circuit may occur in the inductor, which may easily cause the circuit to be damaged due to temperature rise. Therefore, the inductor exception alarm signal may be output for prompting an exception, which helps discover and rectify a fault in time, thereby improving reliability of the power converter.

In this application, the waveform of the current flowing through the inductor when the power converter is just started is collected. When the waveform of the current flowing through the inductor is discontinuous, the inductance value of the inductor is obtained based on the waveform of the current flowing through the inductor. In this way, a status of the inductor can be monitored when the power converter is just started, circuit damage caused by an inductor exception occurred when the power converter is just started is avoided, which can improve reliability and safety of the power converter. In the inductor measurement manner, no additional circuit element needs to be added, and costs are low. The manner can be implemented when the power converter operates, does not affect operating of the power converter, and is convenient and flexible.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power converter, comprising a controller and a direct current-direct current conversion circuit, wherein an input of the direct current-direct current conversion circuit is configured to connect to a photovoltaic module, the direct current-direct current conversion circuit comprises an inductor, a main switch, and a diode, a first end of the inductor is connected to a positive input of the direct current-direct current conversion circuit, a second end of the inductor is connected to a positive electrode of the diode and a first end of the main switch, a negative electrode of the diode is connected to a positive output of the direct current-direct current conversion circuit, a second end of the main switch is connected to a negative input of the direct current-direct current conversion circuit, and the controller is configured to:

in a start process of the power converter, control the main switch to be turned on or turned off, to collect a waveform of a current flowing through the inductor;
when the collected waveform of the current flowing through the inductor is discontinuous, obtain an inductance value of the inductor based on the waveform of the current flowing through the inductor; and
output an inductor exception alarm signal when the obtained inductance value of the inductor is less than a first threshold.

2. The power converter according to claim 1, wherein the controller is specifically configured to:

in the start process of the power converter, control the main switch to be turned on or turned off, and obtain, in a period of a drive signal of the main switch, a plurality of instantaneous values of the current flowing through the inductor, to obtain the waveform of the current flowing through the inductor; and
wherein when at least two consecutive instantaneous values of the current in the plurality of instantaneous values of the current are zero, the waveform of the current flowing through the inductor is discontinuous.

3. The power converter according to claim 1, wherein the controller is specifically configured to:

in the start process of the power converter, control the main switch to be turned on or turned off, and obtain, in a period of a drive signal of the main switch, a plurality of instantaneous values of the current flowing through the inductor, to obtain the waveform of the current flowing through the inductor; and
when an average value of the plurality of instantaneous values of the current is less than a second threshold, the waveform of the current flowing through the inductor is discontinuous.

4. The power converter according to claim 2 or 3, wherein the controller is specifically configured to: when the waveform of the current flowing through the inductor is discontinuous, obtain the inductance value of the inductor based on the plurality of instantaneous values of the current flowing through the inductor that are obtained in the period of the drive signal, an input voltage and an output voltage that are of the direct current-direct current conversion circuit and that are obtained in the period, duration of the period, and a duty cycle of the drive signal.

5. The power converter according to claim 4, wherein the controller is specifically configured to: obtain an average value of the current of the inductor based on the plurality of instantaneous values of the current, and obtain the inductance value of the inductor based on the average value of the current of the inductor, the input voltage, the output voltage, the duration of the period, and the duty cycle.

6. The power converter according to claim 5, wherein the controller is specifically configured to: obtain a voltage difference based on the output voltage and the input voltage, and obtain the inductance value of the inductor based on the average value of the current of the inductor, the input voltage, the output voltage, the voltage difference, the duration of the period, and the duty cycle.

7. The power converter according to any one of claims 2 to 6, wherein the power converter further comprises a current collection unit, the plurality of instantaneous values of the current comprise N instantaneous values of the current, and the current collection unit is configured to: averagely collect, in the period, instantaneous values of the current flowing through the inductor for N times, to obtain the N instantaneous values of the current, and send the N instantaneous values of the current to the controller.

8. The power converter according to any one of claims 4 to 6, wherein the power converter further comprises a voltage collection unit, and the voltage collection unit is configured to: collect the input voltage and the output voltage of the direct current-direct current conversion circuit in the period, and send the input voltage and the output voltage to the controller.

9. The power converter according to any one of claims 1 to 8, wherein the power converter further comprises an inverter circuit, an input of the inverter circuit is connected to an output of the direct current-direct current conversion circuit, and an output of the inverter circuit is configured to connect to a power grid or a load.

10. A method for measuring an inductance value of an inductor of a power converter, wherein the method comprises:

in a start process of the power converter, controlling a main switch in a direct current-direct current conversion circuit comprised in the power converter to be turned on or turned off, to collect a waveform of a current flowing through the inductor in the direct current-direct current conversion circuit;
when the collected waveform of the current flowing through the inductor is discontinuous, obtaining an inductance value of the inductor based on the waveform of the current flowing through the inductor; and
outputting an inductor exception alarm signal when the obtained inductance value of the inductor is less than a first threshold.

11. The method according to claim 10, wherein in the start process of the power converter, the controlling a main switch in a direct current-direct current conversion circuit comprised in the power converter to be turned on or turned off, to collect a waveform of a current flowing through the inductor in the direct current-direct current conversion circuit comprises:

in the start process of the power converter, controlling the main switch in the direct current-direct current conversion circuit to be turned on or turned off, and obtaining, in a period of a drive signal of the main switch, a plurality of instantaneous values of the current flowing through the inductor, to obtain the waveform of the current flowing through the inductor; and when at least two consecutive instantaneous values of the current of the inductor in the plurality of instantaneous values of the current are zero, the waveform of the current flowing through the inductor is discontinuous.

12. The method according to claim 10, wherein in the start process of the power converter, the controlling a main switch in a direct current-direct current conversion circuit comprised in the power converter to be turned on or turned off, to collect a waveform of a current flowing through the inductor in the direct current-direct current conversion circuit comprises:

in the start process of the power converter, controlling the main switch in the direct current-direct current conversion circuit to be turned on or turned off, and obtaining, in a period of a drive signal of the main switch, a plurality of instantaneous values of the current flowing through the inductor, to obtain the waveform of the current flowing through the inductor; and when an average value of the plurality of instantaneous values of the current is less than a second threshold, the waveform of the current of the inductor is discontinuous.

13. The method according to claim 11 or 12, wherein when the collected waveform of the current flowing through the inductor is discontinuous, the obtaining an inductance value of the inductor based on the waveform of the current flowing through the inductor comprises:
when the waveform of the current flowing through the inductor is discontinuous, obtaining the inductance value of the inductor based on the plurality of instantaneous values of the current flowing through the inductor that are obtained in the period of the drive signal, an input voltage and an output voltage that are of the direct current-direct current conversion circuit and that are obtained in the period, duration of the period, and a duty cycle of the drive signal.

14. The method according to claim 13, wherein the obtaining the inductance value of the inductor based on the plurality of instantaneous values of the current flowing through the inductor that are obtained in the period of the drive signal, an input voltage and an output voltage that are of the direct current-direct current conversion circuit and that are obtained in the period, duration of the period, and a duty cycle of the drive signal comprises:
obtaining an average value of the current of the inductor based on the plurality of instantaneous values of the current, and obtaining the inductance value of the inductor based on the average value of the current of the inductor, the input voltage, the output voltage, the duration of the period, and the duty cycle.

15. The method according to claim 14, wherein the obtaining an average value of the current of the inductor based on the plurality of instantaneous values of the current, and obtaining the inductance value of the inductor based on the average value of the current of the inductor, the input voltage, the output voltage, the duration of the period, and the duty cycle comprises:
obtaining a voltage difference based on the output voltage and the input voltage, and obtaining the inductance value of the inductor based on the average value of the current of the inductor, the input voltage, the output voltage, the voltage difference, the duration of the period, and the duty cycle.

Photovoltaic
module

Power converter

DC/DC conversion        DC/AC conversion
circuit                          circuit

DC                    DC

DC                    AC

Power
grid

FIG. 1

Vin

L

D

Q

C0    Vout

FIG. 2

Power converter

FIG. 3

(a)

(b)

FIG. 4

EP 4 641 899 A1

In a start process of a power converter, control a main switch in a direct current-direct current conversion circuit included in the power converter to be turned on or turned off, to collect a waveform of a current flowing through an inductor in the direct current-direct current conversion circuit

S501

When the collected waveform of the current flowing through the inductor is discontinuous, obtain an inductance value of the inductor based on the waveform of the current flowing through the inductor

S502

Output an inductor exception alarm signal when the inductance value of the inductor is less than a first threshold

S503

FIG. 5

Europäisches
Patentamt

European
Patent Office

Office européen
des brevets

# EUROPEAN SEARCH REPORT

**Application Number**

EP 25 17 2365

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | GIVI HADI ET AL: "A Comprehensive Monitoring System for Online Fault Diagnosis and Aging Detection of Non-Isolated DC-DC Converters' Components", IEEE TRANSACTIONS ON POWER ELECTRONICS, INSTITUTE OF ELECTRICAL AND ELECTRONICS ENGINEERS, USA, vol. 34, no. 7, 1 July 2019 (2019-07-01), pages 6858-6875, XP011722087, ISSN: 0885-8993, DOI: 10.1109/TPEL.2018.2875830 [retrieved on 2019-04-30] * figure 1b * * figure 3 * * page 6861 * * page 6865 * * page 6872 * ----- | 1-15 | INV. H02M1/00 H02M1/32 H02M1/36 H02M3/156 |
| Y | "Chapter 5. The Discontinuous Conduction Mode", , 15 July 2020 (2020-07-15), pages 1-37, XP093306624, Retrieved from the Internet: URL:https://ieee.li/pdf/introduction_to_power_electronics/chapter_05.pdf [retrieved on 2025-08-20] * page 29 - page 31 * ----- -/-- | 1-15 | **TECHNICAL FIELDS SEARCHED (IPC)** H02M |

The present search report has been drawn up for all claims

| Place of search | Date of completion of the search | Examiner |
|---|---|---|
| The Hague | 21 August 2025 | Riehl, Philippe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

**Application Number**

EP 25 17 2365

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | "Understanding Boost Power Stages in Switchmode Power Supplies", , 1 March 1999 (1999-03-01), pages 1-32, XP093306618, Retrieved from the Internet: URL:https://www.ti.com/lit/an/slva061/slva061.pdf?ts=1755741157341 [retrieved on 2025-08-20] * page 7 - page 10 * ----- | 1-15 | |
| Y | CN 115 754 484 B (SINENG ELECTRIC CO LTD) 10 November 2023 (2023-11-10) | 2,11 | |
| A | * figure 3 * ----- | 1,3-10, 12-15 | |
| A | ANDERSEN KARSTEN HOLM ET AL: "Predictive digital peak current mode controller with inductor inductance estimation for DC-DC converter", 2015 17TH EUROPEAN CONFERENCE ON POWER ELECTRONICS AND APPLICATIONS (EPE'15 ECCE-EUROPE), JOINTLY OWNED BY EPE ASSOCIATION AND IEEE PELS, 8 September 2015 (2015-09-08), pages 1-8, XP032800456, DOI: 10.1109/EPE.2015.7309456 [retrieved on 2015-10-27] * page 2 - page 5 * ----- | 1-15 | **TECHNICAL FIELDS SEARCHED (IPC)** |

The present search report has been drawn up for all claims

| Place of search | Date of completion of the search | Examiner |
|---|---|---|
| The Hague | 21 August 2025 | Riehl, Philippe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 2365

This annex lists the patent family members relating to the patent documents cited in the above-mentioned European search report.
The members are as contained in the European Patent Office EDP file on
The European Patent Office is in no way liable for these particulars which are merely given for the purpose of information.

21-08-2025

| Patent document cited in search report | Publication date | Patent family member(s) | Publication date |
|---|---|---|---|
| CN 115754484 B | 10-11-2023 | NONE | |

EPO FORM P0459

For more details about this annex : see Official Journal of the European Patent Office, No. 12/82